# EUROPEAN PATENT SPECIFICATION

(11) **EP 0 846 654 B1**
(45) Date of publication and mention of the grant of the patent: **04.06.2003**
(21) Application number: 97402937.3
(22) Date of filing: 04.12.1997
(51) Int. Cl.: C01B 15/013

(54) **On-site manufacture of ultra-high-purity hydrogen peroxide**
In-situ Herstellung von ultrahochreinem Wasserstoffperoxid
Fabrication in-situ de peroxyde d'hydrogène de pureté ultra élevée

(30) Priority: 05.12.1996 US 759214
(43) Date of publication of application: 10.06.1998
(73) Proprietor: Air Liquide America Corporation, Houston, Texas 77056 (US)
(72) Inventor: Ledon, Henri, 78000 Versailles (FR); Carre, Martine, 78000 Versailles (FR); Devos, Christine, 78000 Versailles (FR); Hoffman, Joe G., California 92007 (US); Clark, Scot R., Fallbrook, California, 92028 (US)
(74) Representative: Vesin, Jacques

(56) References cited:
- WO-A-91/01267
- WO-A-92/06918
- WO-A-96/39237
- DATABASE WPI Section Ch, Week 9648 Derwent Publications Ltd., London, GB; Class E36, AN 96-481970 XP002057184 & JP 08 245 204 A (MITSUBISHI GAS CHEM CO INC) , 24 September 1996
- DATABASE WPI Section Ch, Week 9646 Derwent Publications Ltd., London, GB; Class A91, AN 96-461142 XP002057185 & JP 08 231 207 A (MITSUBISHI CHEM CORP) , 10 September 1996

## Description

### BACKGROUND OF THE INVENTION

### 1. Field of the Invention

The present invention relates to various on-site subsystems for providing ultra-high-purity reagents comprising hydrogen peroxide to a point of use. The present invention also relates to methods for the on-site provision of ultra-high-purity reagents comprising hydrogen peroxide to a point of use. The invention has particular applicability in semiconductor fabrication, for providing ultra-high-purity materials to a semiconductor manufacturing operation.

### 2. Description of the Related Art

### a. Contamination Control

Contamination is generally an overwhelmingly important concern in integrated circuit (IC) manufacturing. A large fraction of the steps used in modern integrated circuit manufacturing are cleanup steps of one kind or another. Such cleanup steps are used, for example, to remove organic contaminants, metallic contaminants, photoresist (or inorganic residues thereof), byproducts of etching, native oxides, etc.

As of 1995, the cost of a new front end (IC wafer fabrication facility) was typically more than one billion dollars ($1,000,000,000). A large fraction of the cost for such facilities is directed to measures for particulate control, cleanup, and contamination control.

One important and basic source of contamination in semiconductor fabrication is impurities in the process chemicals. Since the cleanup steps are performed so frequently in and are so critical to IC fabrication, contamination due to cleanup chemistry is very undesirable.

### b. Wet versus Dry Processing

One of the long-running technological shifts in semiconductor processing has been the changes (and attempted changes) between dry and wet processing. In dry processing, only gaseous or plasma-phase reactants come in contact with the wafer or wafers being treated. In wet processing, a variety of liquid reagents are used for a multitude of purposes, such as the etching of silicon dioxide, silicon nitride and silicon, and the removal of native oxide layers, organic materials, trace organic or inorganic contaminants and metals.

While plasma etching has many attractive capabilities, it is not adequate for use in cleanup processes. There is simply no available chemistry with plasma etching to remove some of the most undesirable impurities, such as gold. Thus, wet cleanup processes are essential to modern semiconductor processing, and are likely to remain so for the foreseeable future.

Plasma etching is performed using a photoresist mask in place, and is not immediately followed by high-temperature processes. After plasma etching, the resist is stripped from the wafer surface using, for example, an O₂ plasma treatment. Cleanup of the resist stripped wafer(s) is then necessary.

The materials which the cleanup process should remove include, for example, photoresist residues (organic polymers), sodium, alkaline earth metals (e.g., calcium, magnesium) and heavy metals (e.g., gold). Many of these contaminants do not form volatile halides. As a result, plasma etching will not remove such contaminants from the wafer surface. Hence, cleanup processes using wet chemistries are required.

Because any dangerous contaminants stemming from the plasma etching process are removed prior to high-temperature processing steps by wet chemical treatment, the purities of plasma etching process chemicals (i.e., liquified or compressed gases) are not as critical as those of the liquid chemicals used in cleanup processes. This difference is due to the impingement rate of the liquid chemical at the semiconductor surface typically being one million times greater than that of the plasma species in plasma etching. Moreover, since the liquid cleanup steps are directly followed by high-temperature processes, contaminants on the wafer surface tend to be driven (i.e., diffused) into the wafer.

Wet processing has a major drawback insofar as ionic contamination is concerned. Integrated circuit devices generally use only a few dopant species (e.g., boron, arsenic, phosphorus, and antimony) to form the requisite p-type and n-type doped regions of the device. However, many other species act as electrically active dopants, and are highly undesirable contaminants. These contaminants can have deleterious effects on the IC devices, such as increased junction leakage at concentrations well below 10¹³cm⁻³.

Moreover, some less desirable contaminants segregate into the silicon substrate. This occurs when silicon is in contact with an aqueous solution, and the equilibrium concentration of the contaminants is higher in the silicon than in the solution. Moreover, some less desirable contaminants have very high diffusion coefficients. Consequently, introduction of such contaminants into any part of the silicon wafer may result in diffusion of the contaminants throughout the wafer, including junction locations where leakage may result.

Thus, liquid solutions for treating semiconductor wafers should have extremely low levels of metal ions. Preferably, the concentration of all metals combined should be less than 300 ppt (parts per trillion), and less than 10 ppt for any single metal. Even lower concentrations are desirable. Contamination by anions and cations should also be controlled. Some anions may have adverse effects, such as complexed metal ions which reduce to mobile metal atoms or ions in the silicon lattice.

Front end facilities typically include on-site purification systems for preparation of high-purity water (i.e., "deionized" or "DI" water). However, it is more difficult to obtain liquid process chemicals in the purities required.

### c. Purity in Semiconductor Manufacturing

Undetected contamination of chemicals increases the probability for costly damage to a large quantity of wafers. The extreme purity levels required by semiconductor manufacturing are rare and unique among industrial processes. With such extreme purity requirements, handling of chemicals is undesirable (though of course it cannot be entirely avoided). Exposure of ultrapure chemicals to air (particularly in an environment where workers are also present) should be minimized. Such exposure risks the introduction of particulates into the chemicals, which can result in the contamination of those chemicals. Furthermore, shipment of ultrapure chemicals in closed containers is not ideal, since such containers increase the risk of contaminants being generated at the manufacturer's or at the user's site.

Since many corrosive and/or toxic chemicals are used in semiconductor processing, the reagent supply locations are commonly separated from the locations where front-end workers are present. Construction and maintenance of piping for ultra-high-purity (UHP) gases and liquids are well-understood in the semiconductor industry, and most gases and liquids can be transported to wafer fabrication stations from anywhere in the same building (or in the same site).

### d. Hydrogen Peroxide

Hydrogen peroxide (H₂O₂) is an important process chemical in the semiconductor manufacturing industry. It is commonly used in cleanup solutions. For example, the widely used "piranha" cleanup solution typically uses H₂O₂ + H₂SO₄, in proportions of 30:70; and the widely used "RCA" cleanup is a three-stage cleanup which uses hydrogen peroxide in two of the stages.

Thus, ultra-high-purity (UHP) aqueous hydrogen peroxide is a staple to integrated circuit (IC) manufacturing. Hydrogen peroxide is not an easy chemical to purify, however, since its decomposition is exothermic and temperature sensitive, as well as being catalyzed by various metals and contaminants. Moreover, it is known that H₂O₂ is a powerful oxidant. Substantial work has been done in this area. For example, it has been reported in the literature that an anionic exchange resin for purifying hydrogen peroxide should preferably be loaded with bicarbonate (HCO₃⁻) ions, since other commonly used anions (e.g., OH⁻ and Cl⁻) will catalyze the decomposition of H₂O₂ under some circumstances.

Elimination of organic acidic components contained in H₂O₂ is also described in the literature. See, e.g., French Patent Application No. 1,539,843 (using non-functionalized resins and neutralized base acid); U.S. Patent No. 3,294,488 (basic resin [HCO⁻₃] + CO₂); Japanese Patent No. 6,725,845 (1967) (non-functionalized resins); U.S. Patent No. 297,404 (basic resin [HC₃] and CO); U.S. Patent No. 3,305,314 (basic resin [HCO⁻₃] and CO²⁻₃); and U.S. Patent No. 4,792,403 (halogenated resin).

H₂O₂ purification on cationic and anionic resins (tertiary, quaternary) is described in, for example, French Patent Application No. 10,431 (1953) (use of Sulfonic resins); Polish Patent No. 50,982 (1961) (cationic + anionic resins); Polish Patent No. 55,378 (1968); Spanish Patent No. 328,719 (1961) (sulfonic resins, acrylic, strong base and acid [gel type]); U.S. Patent No. 3,297,404 (1967) (use of mixed resins cationic and anionic [HCO⁻₃]; and U.S. Patent No. 4,999,179 (sulfonic resin + anionic resin [HCO⁻₃], CO²⁻₃ + brominated). Various configurations are described, for example, in French Patent No. 2,677,010 (1992) (strong cationic resin + medium strength anionic resin of the gel type + non-functionalized resin); French Patent No. 2,677,011 (1992) (medium strength anionic resin); and PCT Application No. 92/06918 (1992) (cationic and anionic resins, description of fluidized bed technology).

WO 96/39237, which is comprised in the state of the art according to A. 54(3) EPC, describes the use of an anionic exchange bed that is preconditioned with acid and of a cationic, exchange bed that is preconditioned with bicarbonate ions.

H₂O₂ purification on sulfonic and pyridinic resins is described in, for example, Swedish Patent No. 1,643,452 (1991) (cationic resin ö 2,5 methyl base resins - pyridinic vinyl [HCO₃⁻]); and Japanese Patent No. 62,187,103 (1966) (cationic resins + pyridinic anionic structure).

H₂O₂ purification on resins and chelatants is described in, for example, French Patent No. 2,624,500 (1988) (adding carboxylic or phosphonic chelatant to the basic resin); German Patent No. 3,822,248 (1990) (EDTA added to basic resin), European Patent No. 502,466 (1992) (Chelatant added to H₂O₂ and passing into non-functionalized resin); U.S. Patent No. 5,200,166 (addition of stabilizing acid into H₂O₂ and reacting with basic resin [HCO₃⁻, CO²⁻₃]); European Patent No. 626,342 (1994) (chelatant resin with phosphates <0.1 ppm A⁻ or A⁻/C⁺ + chelatant Al and Fe).

Several patents have also reported success in achieving purities below 1 part per billion (ppb). See, e.g., French Patent No. 624,500 (using resins and complexing agents); WO90/11967 (using SnO₂ ö ultrafiltration); and French Patent Application No. 3,045,504 (using Silica treatment).

### e. Objects and Advantages of the Invention

To meet the requirements of the semiconductor processing industry and to overcome the disadvantages of the related art, it is an object of the present invention to provide novel on-site subsystems for providing ultra-high-purity reagents comprising H₂O₂ to a point of use, in which the hydrogen peroxide can be piped directly to the point of use. The system is very compact, and can be located in the same building as the point of use (or in an adjacent building), such that chemical handling can be avoided. As a result, low impurity levels on a semiconductor wafer surface can be achieved. Ultimately, improvements in device characteristics and increased product yield can be realized.

It is a further object of the invention to provide methods for the on-site provision of ultra-high-purity reagents comprising H₂O₂ to a point of use.

It is, additionally, an object of the present invention to provide an on-site subsystem and method, in a semiconductor device fabrication facility, for providing ultra-high-purity reagents comprising H₂O₂ to a semiconductor manufacturing operation.

Other objects and aspects of the present invention will become apparent to one of ordinary skill in the art upon review of the specification, drawings and claims appended hereto.

### SUMMARY OF THE INVENTION

The foregoing objectives are met by the systems *and* methods of the present invention. According to a first aspect of the present invention, a novel on-site system for providing ultra-high-purity reagents comprising H₂O₂ to a point of use is provided. The subsystem includes: (a) a tank connected to receive aqueous H₂O₂ and to provide a flow of H₂O₂ therefrom; (b) an anionic exchange bed and a cationic exchange bed wherein the cationic exchange bed is preconditioned with acid and the anionic bed is preconditioned with bicarbonate ions connected to receive the flow of H₂O₂from the tank and one or more additional anionic exchange beds and one or more additional cationic exchange beds and to produce therefrom a purified H₂O₂ flow with a reduced level of ionic contaminants. (c) a filter downstream of the anionic exchange bed and the cationic exchange bed; and (d) piping which routes the aqueous H₂O₂ from the filter to the point of use.

According to a second aspect of the invention, an on-site subsystem for providing ultra-high-purity reagents comprising H₂O₂ to a point of use is provided. This subsystem includes the following features: (a) a tank connected to receive aqueous H₂O₂ and to provide a flow of H₂O₂ therefrom and to provide a flow of H₂O₂ therefrom; (b) an anionic exchange bed and a cationic exchange bed connected to receive the flow of H₂O₂ from the tank, and one or more additional anionic exchange beds and one or more cationic exchange beds to produce therefrom a purified H₂O₂ flow with a reduced level of ionic contaminants; (c) an ionic purifier system, connected to pass a gaseous reagent precursor through an area of gas/liquid contact to produce an ultrapure gaseous reagent; (d) generation and mixing subsystems, connected to combine the ultrapure gaseous reagent with deionized water and with the purified H₂O₂ flow to produce an ultrapure cleanup solution; and (e) piping which routes the ultrapure cleanup solution to the point of use. Specific generation and mixing systems and gaseous reagent are defined in the claims.

According to a fourth third aspect of the invention, a novel method usable for the on-site provision of ultra-high-purity reagents comprising H₂O₂ to a point of use is provided. The method includes the step of: (a) providing a flow of aqueous H₂O₂ from a tank which is located at the same site as the point of use; (b) passing the flow of H₂O₂ through an anionic exchange bed and a cationic exchange bed, wherein said cationic exchange bed is preconditioned with acid and said anionic exchange bed is preconditioned bicarbonate ions, and through one or more additional anionic exchange beds and through one or more additional cationic exchange beds, to produce a purified H₂O₂ flow with a reduced level of ionic contaminants, (c) filtering the purified flow, to produce a flow of ultra-purity aqueous H₂O₂ solution.

According to a fourth aspect of the invention, a novel method for the on-site provision of ultra-high-purity reagents comprising H₂O₂ to a point of use is provided. The method includes the steps of: (a) providing a flow of aqueous H₂O₂ from a tank which is located at the same site as the point of use; (b) passing the flow of H₂O₂ through an anionic exchange bed and a cationic exchange bed, wherein the cationic exchange bed is preconditioned with acid and the anionic bed is preconditioned with bicarbonate ions and through one or more additional anionic exchange beds and through one ore more additional cationic exchange beds to produce a purified H₂O₂ flow with a reduced level of ionic contaminants; (c) passing a gaseous reagent precursor through an area of gas/liquid contact in an ionic purifier system to produce an ultrapure gaseous reagent; (d) combining the ultrapure gaseous reagent with deionized water and with the purified H₂O₂ flow to produce an ultrapure cleanup solution; and (e) routing the flow of ultra-purity cleanup solution to the point of use.

### BRIEF DESCRIPTION OF THE DRAWING

The objects and advantages of the invention will become apparent from the following detailed description of the preferred embodiments thereof in connection with the accompanying drawings, in which:
FIG. 1 shows an on-site system for purification of aqueous hydrogen peroxide;
FIG. 2 illustrates a process flow for generating an RCA cleanup solution on-site at a wafer fabrication facility; and
FIG. 3 is a block diagram of semiconductor cleanup stations in a wafer fabrication facility, in which the purification system of FIG. 1 may be incorporated.

### DETAILED DESCRIPTION OF THE PREFERRED EMBODIMENTS OF THE INVENTION

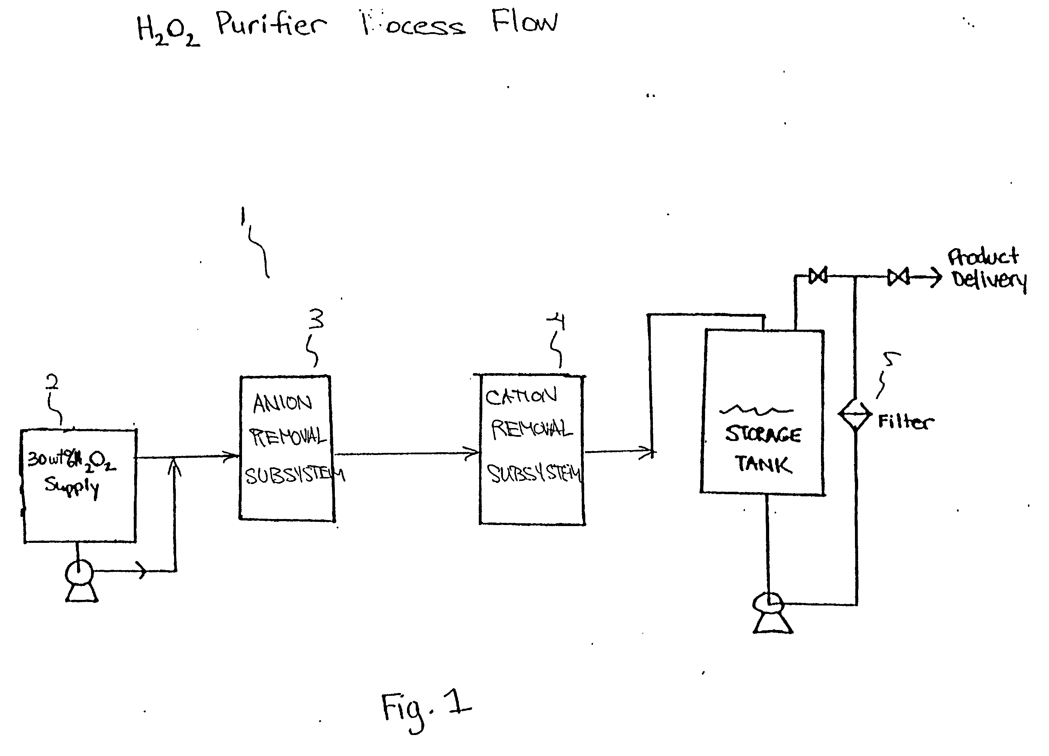

A first embodiment of the invention will now be described with reference to FIG. 1, which illustrates an on-site system and process flow used for hydrogen peroxide ultrapurification. System 1 can be used by itself simply for the preparation of UHP H₂O₂. Alternatively, the system can be used to provide chemicals directly or indirectly to semiconductor process tools.

In accordance with the present invention, incoming H₂O₂ can be purified to impurity levels down to the ppb level. Typical H₂O₂ target impurities according to the invention are as follows:
- cation concentration < 1.0 ppb;
- anion concentration < 20 ppb; and
- total organic contaminants < 20 ppm.

Aqueous H₂O₂ supply 2 is provided in the system. The concentration of the H₂O₂ supply is preferably high-purity (a feed concentration of 30wt% H₂O₂ is shown in FIG. 1 for illustration). In accordance with the invention, incoming aqueous H₂O₂ supply 2 is further purified in on-site purification units before being made available for combination with other reagents and subsequent feed to process tools. The on-site purification units preferably include an anionic exchange bed 3 and a cationic exchange bed 4, together with one or more particulate filters 5. Suitable particulate filters are well known to persons skilled in the art.

The containers and piping used in the ultrapurification system are preferably selected from among materials which are inert and non-catalytic to H₂O₂. Inert fluoropolymers are preferred, since most metals catalyze H₂O₂ decomposition at least to some extent.

In a preferred embodiment of the on-site ultrapurification system, an anionic exchange column 3 is used in combination with a cationic exchange column 4. However, other conventional techniques for sub-ppb polishing can alternatively be used.

The ultrapurification system further preferably has a filtration stage 5 disposed downstream from the anion and cation exchange resin columns 3 and 4. Filter stage 5 allows for the removal of any particulates which may have been introduced by columns 3 and 4.

The anionic exchange column is preferably preconditioned by initially loading the column with bicarbonate ions. Bicarbonate preconditioning is described, for example, in U.S. Patent Nos. 3,294,488 and 3,305,314. The bicarbonate preconditioning step is preferably achieved by use of a concentrated NH₄HCO₃ solution. Possible alternatives to the use of NH₄HCO₃ include, for example, use of an alkali bicarbonate, which requires removal of the alkali metal ions, or use of CO₂, which is inefficient due to the low solubility of CO₂.

In a preferred embodiment, the anionic resin is DOWEX MONOSPHERE® A550 UPN (polystyrene - DVB gel, quaternary ammonium, 1.0 eq OH⁻/l) nuclear grade, from Dow. Other anionic resins, however, can be used, such as AMBERLITE IRA® 958, from Rohm and Haas (polyacrylic - DVB macroporous, quaternary ammonium 0.8 eq. Cl⁻/l). The cationic exchange column 4 is preferably preconditioned with an acid. This can be done, for example, by washing the cationic exchange column with H₂SO₄ (e.g., a 10wt% solution). According to a preferred embodiment, the cationic resin is DOWEX MONOSPHERE® C650 UPN (polystyrene - DVB gel, sulfonic, 1.9 eq. H⁻/l),from Dow. Additional suitable cationic resins include, for example, IRA 963 from Rohm and Haas.

While the ultrapurification system illustrated in FIG. 1 depicts a single anionic exchange column and a single cationic exchange column, the system has a plurality of anionic and/or cationic exchange columns. In such a case, the plural anionic exchange columns can be placed in series with or in parallel to each other. The plural cationic exchange columns can be configured in a similar manner. In a preferred embodiment, there are two anionic and two cationic exchange columns in series, with the two anionic columns preceding the cationic exchange columns. Other configurations of plural exchange columns will be apparent to those skilled in the art.

Additionally to the use of separate anionic and cationic exchange columns, one or more anionic/cationic mixed beds can be used. When a mixed bed is used in addition to the anionic and cationic exchange columns, the mixed bed is preferably disposed downstream of the anionic and cationic exchange columns.

Suitable mixed bed resins are known in the art, and include, for example, 50/50 DOWEX MONOSPHERE® A550 and C650. In the event a mixed bed is used, the resins cannot be preconditioned in situ but must be conditioned prior to packing into the bed.

The following example illustrates the effects of different types of resins or elemental impurities in the H₂O₂ product.

### EXAMPLE

Identical conditions were used for each of the resins and the analysis of H₂O₂ was made before and after the purification column.

Various types of resins were investigated for their suitability as exchange resins in H₂O₂ ultrapurification processes. The resins investigated are set forth below:

### Cationic resin (nuclear grade):

- DOWEX® C75 NGH (Polystyrene-DVB macroporous 20% DVB, sulfonic, 1.7 eq H⁺/1.)
- DOWEX® MONOSPHERE C650 UPN (polystyrene-DVB gel, sulfonic, 1.9 eq H⁺/1.)

### Anionic resin

- DOWEX® MONOSPHERE A550 UPN (polystyrene-DVB gel, quaternary ammonium, 1.0 eq OH⁻/1.) nuclear grade.
- AMBERLITE® IRA 958 de Rohm & Haas (polyacrylic-DVB macroporous, quaternary ammonium 0.8 eq Cl⁻/l.)

### Chelate resin

- CHELEX® 100 from Bio-Rad, amino-diacetic, 0.4 eq Na⁺/l.

### Mix bed resin

- 50/50 DOWEX® MONOSPHERE A550 and C650.

750 ml of H₂O₂ was purified for each resin type in an ion exchange column. Three 125 ml samples were taken for analysis, one sample from each 250 ml.

Analysis was carried out using inductively coupled plasma (ICP)/mass spectroscopy (MS) by direct introduction of H₂O₂ samples. The following table summarizes the results obtained for each of the resins. The values obtained for the H₂O₂ HP grade used at the entrance of the purification column are also provided. The results are shown in the Table below.

| ppt(ng/kg) | | | CATIONIC | | ANIONIC | | MIXED BED | H₂O₂ (HP grade) | CHELEX 100 |
|---|---|---|---|---|---|---|---|---|---|
| Mass | Elem | H₂O₂ (HP grade) | C75NGH | C650 | IRA958 | A550 | C650/A550 | | |
| 23 | Na | 34230 | 66 | 99 | 10363 | 34857 | 152 | 37040 | 42660 |
| 24 | Mg | 33 | 3.3 | 6.9 | 193 | 1073 | 15 | 34 | 2.4 |
| 27 | Al | 2096 | 2516 | 2381 | 237 | 354 | 218 | 2774 | 2554 |
| 39 | K | 68 | 18 | 29 | 125 | 83 | 20 | 67 | 4602 |
| 40 | Ca | 84 | 13 | 17 | 164 | 949 | 19 | 121 | 27 |
| 52 | Cr | 47 | 37 | 45 | 10 | 13 | 14 | 55 | 49 |
| 55 | Mn | 6.6 | 3.1 | 2.7 | 20 | 11 | 4.4 | 9.4 | 3.8 |
| 56 | Fe | 209 | 278 | 404 | 74 | 271 | 128 | 261 | 292 |
| 58 | Ni | 50 | 15 | 29 | 59 | 66 | 16 | 53 | 11 |
| 59 | Co | 4.1 | 2.4 | 3.4 | 6.1 | 21 | 2.6 | | |
| 63 | Cu | 7.7 | 6.6 | 16 | 7.0 | 6.8 | 6.3 | 8.9 | 6.1 |
| 66 | Zn | 506 | 3.7 | 3.2 | 535 | 500 | 3.9 | | |

For the single columns investigated, the best results were obtained for the mixed bed column. With the mixed bed, impurity concentration values of less than 200 ppt were obtained for each element except At with one purification of HP grade H₂O₂ (<100 ppb).

The cationic resins were able to purify the H₂O₂ except for Aℓ and Fe for which an increase was observed. (These two elements are not retained on cationic resins.)

With the anionic resins, Aℓ and Fe were purified, as expected. However, the level obtained was still high (>200 ppt). Moreover, an increase of Mg, K, and Ca was observed which probably stems from the chemical preparation of the resins prior to H₂O₂ processing. Poor results were also observed with chelate resin.

The present invention also contemplates a system and method for the on-site preparation of ultra-high-purity mixed cleanup solutions. This aspect of the invention involves the combination of on-site ultrapurified hydrogen peroxide with an acid or base which has also been ultrapurified on-site. The described system and method find particular applicability when used in a semiconductor manufacturing facility.

Of the mixed cleanup solutions which can be prepared in accordance with the invention, preparation of the RCA acidic cleanup and the RCA basic cleanup on-site at a semiconductor fabrication facility is of particular interest. The chemicals involved in the RCA cleanup process include the following: (1) a solvent wash, such as tetrachloroethylene or a comparable solvent, to remove gross organic contaminants; (2) basic cleanup including treatment with NH₄OH + H₂O₂ + H₂O; and (3) an acid cleanup with HCl + H₂O₂ + H₂O). See, W. Runyan et al, Semiconductor Integrated Circuit Processing Technology (1990), For semiconductor manufacturing, such cleanup reagents are normally purchased as packaged containers. However, this implies that some handling of the solutions in those containers will be necessary, both at the manufacturer's plant and at the place of use. As noted above, such handling of ultra-high purity chemicals is undesirable.

Various other cleanup chemistries have also been proposed. For example, the Shiraki cleanup is an aggressive, pre-epitaxy cleanup. This process adds a nitric acid treatment step to the cleanup sequence, and uses somewhat higher temperatures and concentrations than the RCA cleanup process. See Ishizaki and Shiraki, *Low Temperature Surface Cleaning of Silicon* and *its Application to Silicon MBE,* 133 J. ELECTROCHEM. Soc. 666 (1986).

The RCA basic cleanup solution typically consists of NH₄OH + H₂O₂ + H₂O in proportions of 1:1:5 or 1:2:7. In accordance with the invention, the RCA basic cleanup (or analogous cleanup solutions) can be generated on-site. Such solutions are formed by the combination of ultra-pure ammonia with ultra-pure hydrogen peroxide, both of which have been purified on-site. By the present invention, chemical purity is increased, while the risk of undetected accidental contamination is reduced.

The RCA acid cleanup solution typically includes HCl + H₂O₂ + H₂O in proportions of 1:1:6 or 1:2:8. The RCA acid cleanup (or analogous cleanup solutions) can be generated on-site at a wafer manufacturing plant, by combination of ultra-pure HCl with ultra-pure hydrogen peroxide, both of which have been purified on-site. Thus purity is increased, and the risk of undetected accidental contamination is reduced.

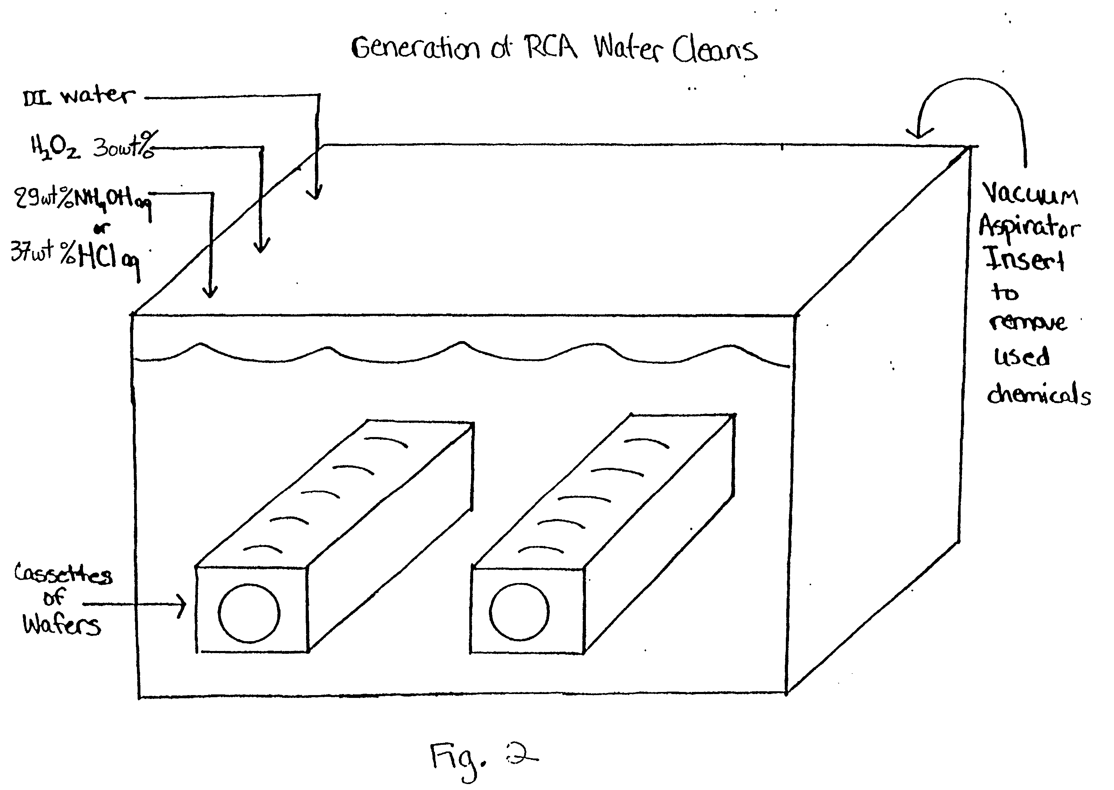

FIG. 2 illustrates the generation of an RCA cleanup solution on-site, at a wafer fabrication facility, using two components (30wt% H₂O₂ and 29wt% NH₄OH_{aq} or 37wt% HCl_{aq}) in addition to ultrapure water. The two components are preferably ultrapurified on-site prior to mixing in the cleaning station.

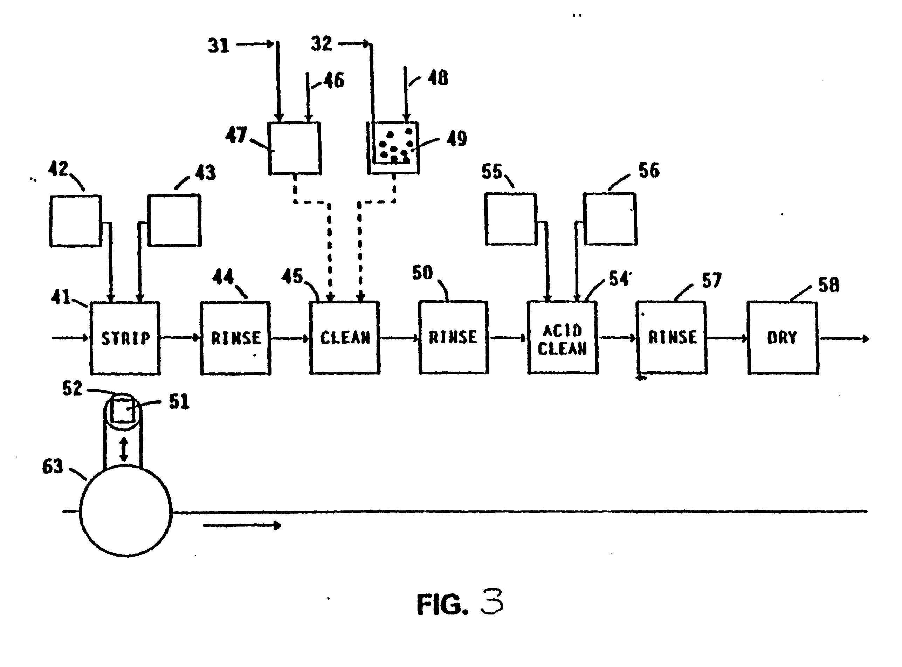

FIG. 3 shows a wafer cleaning system in a semiconductor fabrication line. According to the illustrated embodiment, wafer or wafer batch 51 is held on a wafer support 52 and conveyed from one work station to the next by a robot 63 or some other conventional means for achieving sequential treatment. The means of conveyance may be totally automated, partially automated, or not automated at all.

The first unit in the cleaning line is a photoresist stripping station 41, in which aqueous hydrogen peroxide 42 and sulfuric acid 43 are combined and applied to the semiconductor surface to strip off the resist. Next in line is a rinse station 44, where deionized water is applied to rinse off the previously applied stripping solution. Immediately downstream of the rinse station 44, is a cleaning station 45. In cleaning station 45, an aqueous solution of ammonia and hydrogen peroxide are applied to a wafer or wafer batch 51.

The ammonia/hydrogen peroxide solution can be supplied in two ways. According to a first method, aqueous ammonia 31 from a dissolving unit is combined with aqueous hydrogen peroxide 46, and the resulting mixture 47 is directed to cleaning station 45. In the second method, pure gaseous ammonia 32 is bubbled into an aqueous hydrogen peroxide solution 48 to produce a mixture 49, which is directed to cleaning station 45.

Once cleaned with the ammonia/hydrogen peroxide combination, the semiconductor passes to a second rinse station 50 where deionized water is applied to remove the cleaning solution. The next station is an additional cleaning station 54, in which aqueous solutions of HCℓ 55 and H₂O₂ 56 are combined and applied to the semiconductor surface for further cleaning.

The purified HCℓ for the acid cleaning station 54 may be prepared and supplied on-site in a manner similar to that of the hydrogen peroxide purification system of FIG. 1. This step is followed by a final rinse station 57 where deionized water is applied to remove the HCℓ and H₂O₂, and finally a drying station 58, in which the wafer or wafer batch 51 is dried.

The system shown in FIG. 3 is exemplary of cleaning lines used in semiconductor fabrication. In practice, cleaning lines can vary widely from the specific system shown in FIG. 3. For example, one or more of the units shown in FIG. 3 can be eliminated. Conversely, units not shown in FIG. 3 can optionally be added. While the specific configuration of the processing tool may vary, the system and method for on-site preparation of high-purity hydrogen peroxide and reagents including hydrogen peroxide in accordance with the invention are applicable to all such systems.

The use of ammonia and hydrogen peroxide as a semiconductor cleaning medium at workstations such as cleaning station 45 in FIG. 3 is well known. While the proportions of the cleaning medium components vary, an exemplary system uses deionized water, 29 wt% ammonium hydroxide and 30 wt% hydrogen peroxide, combined in a volume ratio of 6:1:1. This cleaning agent is used to remove organic residues. When used in conjunction with ultrasonic agitation at frequencies of approximately 1 MHz, particles down to the submicron range can be removed.

The on-site system for ultrapurification of H₂O₂ and generation of ultrapure cleaning solutions can be connected to a point of use in the production line by piping which prevents exposure of the chemicals to an uncontrolled ambient and does not introduce contamination. In most applications, stainless steel or polymers such as high density polyethylene or fluorinated polymers are suitable materials of construction for the transfer lines.

The distance of travel between the unit and the production line can be short (e.g., in the case of a dedicated point-of-use mixing facility). However, in a more preferable embodiment, the ultrapure cleaning solution generator can be connected to multiple points of use. The generation system and points of use can be connected through ultraclean piping.

In large systems, intermediate holding tanks can be used to average the flow rate in order to compensate for varying demand. In any case, the cleaning solutions are maintained in an ultrapure environment, and are not exposed to ambient contamination. As a result, the risks of contamination due to packaging, transport, and transfer between containers can be avoided.

The distance between the point at which a cleanup solution leaves the generation system and the point of use in the production line can vary, for example, from one foot (30 cm) up to 1,000 meters or more. Greater distances are typically used when ultraclean piping is routed between buildings at a single manufacturing site.

Due to the proximity of the ultrapure purification, generation and/or mixing units to the production line, deionized water (purified in accordance with well known semiconductor manufacturing standards) is readily available for purposes such as concentration adjustment, flushing, and dissolution of gases.

The standards commonly used in the semiconductor manufacturing industry are well known among those skilled in the art. For example, typical standards for the purity of water used in these semiconductor manufacturing processes include a resistivity of at least about 15 megohm-cm at 25°C (typically 18 megohm-cm at 25°C), less than about 25 ppb of electrolytes, a particulate content of less than about 150/cm³, a particle size of less than 0.2 micron, a microorganism content of less than about 10/cm³, and total organic carbon of less than 100 ppb. Additives can be introduced into the purification water if desired.

In the method and system according to the invention, a high degree of control over the product concentration and, hence, flow rates is preferably maintained, by precise monitoring and metering using known equipment and instrumentation. A convenient means of achieving such control is ultrasonic wave propagation to monitor density. Other methods will be readily apparent to those skilled in the art.

In summary, the invention can be used as an on-site system for providing ultrapure chemicals to a point of use. The purification system can also be adapted to operate as part of a manufacturing unit for producing ultra-high-purity chemicals which are to be shipped. However, when used in this manner, many of the advantages gained with on-site purification cannot be realized. This is a result of the inherent risks in the handling of ultra-high-purity chemicals. Nevertheless, for customers requiring packaged chemicals, the inventive system and method at least provide an initial chemical purity which is higher than that available by other preparation techniques. Again, in such applications a dryer stage may also be used after the ionic purifier.

While the invention has been described in detail with reference to specific embodiments thereof, it will be apparent to those skilled in the art that various changes and modifications can be made, and equivalents employed, without departing from the scope of the appended claims. For example, the disclosed innovative techniques can be applied to the manufacture of products other than ICs, such as discrete semiconductor components (e.g., optoelectronic and power devices), and to other manufacturing technologies in which IC manufacturing methods have been adopted (e.g., the manufacture of thin-film magnetic heads and active-matrix liquid-crystal displays).

## Claims

1. An on-site subsystem for providing ultra-high-purity reagents comprising H202 to a point of use, comprising:
(a) a tank connected to receive aqueous H202 and to provide a flow of H202 therefrom ;
(b) an anionic exchange bed and a cationic exchange bed wherein said cationic exchange bed is preconditioned with acid and said anionic bed is preconditioned with bicarbonate ions connected to receive said flow of H202 from said tank, and one or more additional anionic exchange beds and one or more additional cationic exchange beds, to produce therefrom a purified H202 flow with a reduced level of ionic contaminants;
(c) a filter downstream of said anionic exchange beds and said cationic exchange beds; and
(d) piping which routes said aqueous H202 from said filter to said point of use.

2. The on-site subsystem according to claim 1, wherein the subsystem and the point of use are located in a semiconductor fabrication facility.

3. The on-site subsystem according to claims 1 or 2, further comprising one or more mixed anionic/cationic exchange beds.

4. An on-site subsystem for providing ultra-high-purity reagents comprising H202 to a point of use, comprising:
(a) a tank connected to receive aqueous H202 and to provide a flow of H202 therefrom ;
(b) an anionic exchange bed and a cationic exchange bed connected to receive said flow of H202 from said tank, and one or more additional anionic exchange beds and one or more additional cationic exchange beds, to produce therefrom a purified H202 with a reduced level of ionic contaminants;
(c) an ionic purifier system, connected to pass a gaseous reagent precursor through an area of gas/liquid contact to produce an ultrapure gaseous reagent;
(d) generation and mixing subsystems, connected to combine said ultrapure gaseous reagent with deionozed water and with said purified H202 flow to produce an ultrapure cleanup solution ; and
(e) piping which routes said ultrapure cleanup solution to the point of use.

5. The on-site subsystem according to claim 4, wherein the subsystem and the point of use are located in a semiconductor device fabrication facility.

6. The on-site subsystem according to one of claims 4 or 5, wherein the generation and mixing subsystems are separate.

7. The on-site subsystem according to one of claims 4 or 5, wherein the generation and mixing subsystems are combined.

8. The on-site subsystem according to one of claims 4 to 7, wherein the gaseous reagent is HCl.

9. The on-site subsystem according to one of claims 4 to 7, wherein the gaseous reagent is NH3.

10. A method for preparing ultra-high-purity reagents comprising H202, comprising the steps of
(a) providing a flow of aqueous H202 from a tank;
(b) passing said flow of H202 through an anionic exchange bed and a cationic exchange bed, wherein said cationic exchange bed is preconditioned with acid and said anionic bed is preconditioned with bicarbonate ions, and through one or more additional anionic exchange beds and through one or more additional cationic exchange beds to produce a purified H202 flow with a reduced level of ionic contaminants ; and
(c) filtering said purified flow, to produce a flow of ultra-high-purity aqueous H202 solution.

11. The method according to claim 10, wherein during step (a) the flow of H202 is further passed through a mixed anionic/cationic exchange bed.

12. The method of claims 10 or 11 used for the on-site provision of ultra-huh-purity reagents comprising H202 to a point of use and comprising further the step of (d) routing said flow of ultra-purity aqueous H202 solution through piping to the point of use.

13. The method according to claim 12, wherein the point of use is located in a semiconductor device fabrication facility.

14. A method for preparing ultra-high-purity reagents comprising H202, comprising the steps of:
(a) providing a flow of aqueous H202 from a tank which is located at the same site as the point of use;
(b) passing said flow of H202 through an anionic exchange bed and a cationic exchange bed, wherein said cationic exchange bed is preconditioned with acid and said anionic bed is preconditioned with bicarbonate ions, and through one or more additional anionic exchange beds and through one or more additional cationic exchange beds to produce a purified H202 flow with a reduced level of ionic contaminants;
(c) passing a gaseous reagent precursor through an area of gas/liquid contact in an ionic purifier system to produce an ultrapure gaseous reagent;
(d) combining said ultrapure gaseous reagent with deionized water and with said purified H202 flow to produce an ultrapure cleanup solution.

15. The method according to claim 14, wherein during step (a) the flow of H202 is further passed through a mixed anionic/cationic exchange bed.

16. The method according to claim 14 or 15, wherein the gaseous reagent is HCl.

17. The method according to one of claims 14 or 15, wherein the gaseous reagent is NH3.

18. The method according to one of claims 14 to 17 used for the on-site provision of ultra-high-purify reagents comprising H202 to a point of use and comprising further the step of (e) routing said flow of ultra-purity cleanup solution to the point of use.

19. The method according to claim 18, wherein the point of use is located in a semiconductor device fabrication facility.

## Patentansprüche

1. Vor-Ort-Subsystem zur Versorgung eines Verwendungsortes mit ultrahochreinen H₂O₂-Reagenzien, enthaltend:
(a) einen Behälter zum Empfangen von wäßrigem H₂O₂ und zur Bereitstellung eines H₂O₂-Stroms daraus;
(b) ein mit Hydrogencarbonationen vorkonditioniertes Anionenaustauscherbett und ein mit Säure vorkonditioniertes Kationenaustauscherbett zum Empfangen des H₂O₂-Stroms aus dem Behälter und ein oder mehrere zusätzliche Anionenaustauscherbetten und ein oder mehrere zusätzliche Kationenaustauscherbetten, um daraus einen gereinigten H₂O₂-Strom mit einem verringerten Gehalt an ionischen Verunreinigungen herzustellen;
(c) ein den Anionenaustauscherbetten und Kationenaustauscherbetten nachgeschaltetes Filter und
(d) ein Leitungssystem, das das wäßrige H₂O₂ vom Filter dem Verwendungsort zuführt.

2. Vor-Ort-Subsystem nach Anspruch 1, bei dem sich das Subsystem und der Verwendungsort in einer Halbleiterfertigungsanlage befinden.

3. Vor-Ort-Subsystem nach Anspruch 1 oder 2, ferner enthaltend ein oder mehrere gemischte Anionen/Kationenaustauscherbetten.

4. Vor-Ort-Subsystem zur Versorgung eines Verwendungsortes mit ultrahochreinen H₂O₂-Reagenzien, enthaltend:
(a) einen Behälter zum Empfangen von wäßrigem H₂O₂ und zur Bereitstellung eines H₂O₂-Stroms daraus;
(b) ein Anionenaustauscherbett und ein Kationenaustauscherbett zum Empfangen des H₂O₂-Stroms aus dem Behälter und ein oder mehrere zusätzliche Anionenaustauscherbetten und ein oder mehrere zusätzliche Kationenaustauscherbetten, um daraus einen gereinigten H₂O₂-Strom mit einem verringerten Gehalt an ionischen Verunreinigungen herzustellen;
(c) ein Ionenreinigersystem zum Hindurchleiten eines Vorläufers für ein gasförmiges Reagenz durch einen Gas/Flüssigkeit-Kontaktbereich zur Herstellung eines ultrareinen gasförmigen Reagenzes;
(d) Erzeugungs- und Mischsubsysteme zum Kombinieren des ultrareinen gasförmigen Reagenzes mit entionisiertem Wasser und mit dem gereinigten H₂O₂-Strom zur Herstellung einer ultrareinen Reinigungslösung und
(e) ein Leitungssystem, das die ultrareine Reinigungslösung dem Verwendungsort zuführt.

5. Vor-Ort-Subsystem nach Anspruch 4, bei dem sich das Subsystem und der Verwendungsort in einer Fertigungsanlage für Halbleitervorrichtungen befinden.

6. Vor-Ort-Subsystem nach Anspruch 4 oder 5, bei dem die Erzeugungs- und Mischsubsysteme voneinander getrennt sind.

7. Vor-Ort-Subsystem nach Anspruch 4 oder 5, bei dem die Erzeugungs- und Mischsubsysteme kombiniert sind.

8. Vor-Ort-Subsystem nach einem der Ansprüche 4 bis 7, bei dem es sich bei dem gasförmigen Reagenz um HCl handelt.

9. Vor-Ort-Subsystem nach einem der Ansprüche 4 bis 7, bei dem es sich bei dem gasförmigen Reagenz um NH₃ handelt.

10. Verfahren zur Herstellung von ultrahochreinen H₂O₂-Reagenzien, bei dem man:
(a) aus einem Behälter einen Strom von wäßrigem H₂O₂ bereitstellt;
(b) den H₂O₂-Strom durch ein mit Hydrogencarbonationen vorkonditioniertes Anionenaustauscherbett und ein mit Säure vorkonditioniertes Kationenaustauscherbett und durch ein oder mehrere zusätzliche Anionenaustauscherbetten und durch ein oder mehrere zusätzliche Kationenaustauscherbetten leitet, wobei man einen gereinigten H₂O₂-Strom mit einem verringerten Gehalt an ionischen Verunreinigungen erhält; und
(c) den gereinigten Strom filtriert, wobei man einen Strom von ultrahochreiner wäßriger H₂O₂-Lösung erhält.

11. Verfahren nach Anspruch 10, bei dem man bei Schritt (a) den H₂O₂-Strom außerdem auch noch durch ein gemischtes Anionen/Kationenaustauscherbett leitet.

12. Verfahren nach Anspruch 10 oder 11 zur Vor-Ort-Versorgung eines Verwendungsortes mit ultrahochreinen H₂O₂-Reagenzien, bei dem man ferner
(d) den Strom von ultrareiner wäßriger H₂O₂-Lösung durch ein Leitungssystem dem Verwendungsort zuführt.

13. Verfahren nach Anspruch 12, bei dem sich der Verwendungsort in einer Fertigungsanlage für Halbleitervorrichtungen befindet.

14. Verfahren zur Herstellung von ultrahochreinen H₂O₂-Reagenzien, bei dem man:
(a) aus einem Behälter, der sich am gleichen Standort wie der Verwendungsort befindet, einen Strom von wäßrigem H₂O₂ bereitstellt;
(b) den H₂O₂-Strom durch ein mit Hydrogencarbonationen vorkonditioniertes Anionenaustauscherbett und ein mit Säure vorkonditioniertes Kationenaustauscherbett und durch ein oder mehrere zusätzliche Anionenaustauscherbetten und durch ein oder mehrere zusätzliche Katiönenaustauscherbetten leitet, wobei man einen gereinigten H₂O₂-Strom mit einem verringerten Gehalt an ionischen Verunreinigungen erhält;
(c) einen Vorläufer für ein gasförmiges Reagenz durch einen Gas/Flüssigkeit-Kontaktbereich in einem Ionenreinigersystem leitet, wobei man ein ultrareines gasförmiges Reagenz erhält; und
(d) das ultrareine gasförmige Reagenz mit entionisiertem Wasser und mit dem gereinigten H₂O₂-Strom kombiniert, wobei man eine ultrareine Reinigungslösung erhält.

15. Verfahren nach Anspruch 14, bei dem man bei Schritt (a) den H₂O₂-Strom außerdem auch noch durch ein gemischtes Anionen/Kationenaustauscherbett leitet.

16. Verfahren nach Anspruch 14 oder 15, bei dem es sich bei dem gasförmigen Reagenz um HCl handelt.

17. Verfahren nach Anspruch 14 oder 15, bei dem es sich bei dem gasförmigen Reagenz um NH₃ handelt.

18. Verfahren nach einem der Ansprüche 14 bis 17 zur Vor-Ort-Versorgung eines Verwendungsortes mit ultrahochreinen H₂O₂-Reagenzien, bei dem man ferner (e) den Strom von ultrareiner Reinigungslösung dem Verwendungsort zuführt.

19. Verfahren nach Anspruch 18, bei dem sich der Verwendungsort in einer Fertigungsanlage für Halbleitervorrichtungen befindet.

## Revendications

1. Sous-système sur site pour fournir des réactifs ultra purs comprenant H₂O₂ à un point de service, comprenant :
(a) une cuve raccordée pour recevoir H₂O₂ aqueux et fournir un courant de H₂O₂ ;
(b) un lit d'échange d'anions et un lit d'échange de cations, ledit lit d'échange de cations étant préconditionné avec un acide et ledit lit d'échange d'anions étant préconditionné avec des ions bicarbonate, raccordés pour recevoir ledit courant de H₂O₂ issu de ladite cuve, et un ou plusieurs autres lits d'échange d'anions et un ou plusieurs autres lits d'échange de cations, pour en produire un courant de H₂O₂ purifié comportant un niveau réduit de contaminants ioniques ;
(c) un filtre en aval desdits lits d'échange d'anions et desdits lits d'échange de cations ; et
(d) une canalisation qui dirige ledit H₂O₂ aqueux dudit filtre jusqu'au dit point de service.

2. Sous-système sur site selon la revendication 1, dans lequel le sous-système et le point de service sont situés dans une usine de fabrication de semi-conducteurs.

3. Sous-système sur site selon la revendication 1 ou 2, comprenant en outre un ou plusieurs lits d'échange d'anions/de cations mélangés.

4. Sous-système sur site pour fournir des réactifs ultra purs comprenant H₂O₂ à un point de service, comprenant :
(a) une cuve raccordée pour recevoir H₂O₂ aqueux et pour fournir un courant de H₂O₂ ;
(b) un lit d'échange d'anions et un lit d'échange de cations raccordés pour recevoir ledit courant de H₂O₂ en provenance de ladite cuve, et un ou plusieurs autres lits d'échange d'anions et un ou plusieurs autres lits d'échange de cations, pour en produire un courant de H₂O₂ purifié comportant un niveau réduit de contaminants ioniques ;
(c) un système purificateur ionique, raccordé pour envoyer un précurseur de réactif gazeux à travers une zone de contact gaz/liquide pour produire un réactif gazeux ultra pur ;
(d) des sous-systèmes de production et de mélange, raccordés pour combiner ledit réactif gazeux ultra pur avec de l'eau déminéralisée et avec ledit courant de H₂O₂ purifié pour produire une solution de nettoyage ultra pure ; et
(e) une canalisation qui dirige ladite solution de nettoyage ultra pure jusqu'au dit point de service.

5. Sous-système sur site selon la revendication 4, dans lequel le sous-système et le point de service sont situés dans une usine de fabrication de dispositifs à semi-conducteurs.

6. Sous-système sur site selon l'une quelconque des revendications 4 ou 5, dans lequel les sous-systèmes de production et de mélange sont séparés.

7. Sous-système sur site selon l'une quelconque des revendications 4 ou 5, dans lequel les sous-systèmes de production et de mélange sont combinés.

8. Sous-système sur site selon l'une quelconque des revendications 4 à 7, dans lequel le réactif gazeux est HCl.

9. Sous-système sur site selon l'une quelconque des revendications 4 à 7, dans lequel le réactif gazeux est NH₃.

10. Procédé de préparation de réactifs ultra purs comprenant H₂O₂, comprenant les étapes consistant à :
(a) se procurer un courant de H₂O₂ aqueux provenant d'une cuve ;
(b) envoyer ledit courant de H₂O₂ à travers un lit d'échange d'anions et un lit d'échange de cations, ledit lit d'échange de cations étant préconditionné avec un acide et ledit lit d'échange d'anions étant préconditionné avec des ions bicarbonate, et à travers un ou plusieurs autres lits d'échange d'anions et à travers un ou plusieurs autres lits d'échange de cations, pour produire un courant de H₂O₂ purifié comportant un niveau réduit de contaminants ioniques ; et
(c) filtrer ledit courant purifié, pour produire un courant de solution aqueuse de H₂O₂ ultra pure.

11. Procédé selon la revendication 10, dans lequel, durant l'étape (a), le courant de H₂O₂ est ensuite envoyé à travers un lit d'échange d'anions/de cations mélangés.

12. Procédé selon la revendication 10 ou 11 utilisé pour fournir sur site des réactifs ultra purs comprenant H₂O₂ à un point de service et comprenant en outre l'étape (d) consistant à diriger ledit courant de solution aqueuse de H₂O₂ ultra pure à travers une canalisation jusqu'au point de service.

13. Procédé selon la revendication 12, dans lequel le point de service est situé dans une usine de fabrication de dispositifs à semi-conducteurs.

14. Procédé de préparation de réactifs ultra purs comprenant H₂O₂, comprenant les étapes consistant à :
(a) se procurer un courant de H₂O₂ aqueux provenant d'une cuve qui est située sur le même site que le point de service ;
(b) envoyer ledit courant de H₂O₂ à travers un lit d'échange d'anions et un lit d'échange de cations, ledit lit d'échange de cations étant préconditionné avec un acide et ledit lit d'échange d'anions étant préconditionné avec des ions bicarbonate, et à travers un ou plusieurs autres lits d'échange d'anions et à travers un ou plusieurs autres lits d'échange de cations, pour produire un courant de H₂O₂ purifié comportant un niveau réduit de contaminants ioniques ;
(c) envoyer un précurseur de réactif gazeux à travers une zone de contact gaz/liquide dans un système purificateur ionique pour produire un réactif gazeux ultra pur ;
(d) combiner ledit réactif gazeux ultra pur avec de l'eau déminéralisée et avec ledit courant de H₂O₂ purifié pour produire une solution de nettoyage ultra pure.

15. Procédé selon la revendication 14, dans lequel, durant l'étape (a), le courant de H₂O₂ est ensuite envoyé à travers un lit d'échange d'anions/de cations mélangés.

16. Procédé selon la revendication 14 ou 15, dans lequel le réactif gazeux est HCl.

17. Procédé selon l'une des revendications 14 ou 15, dans lequel le réactif gazeux est NH₃.

18. Procédé selon l'une des revendications 14 à 17 utilisé pour fournir sur site des réactifs ultra purs comprenant H₂O₂ à un point de service et comprenant en outre l'étape (e) consistant à diriger ledit courant de solution de nettoyage ultra pure jusqu'au point de service.

19. Procédé selon la revendication 18, dans lequel le point de service est situé dans une usine de fabrication de dispositifs à semi-conducteurs.
